(19) Europäisches Patentamt
European Patent Office
Office européen des brevets

(11) **EP 3 671 523 A2**

(12) **EUROPEAN PATENT APPLICATION**

(43) Date of publication:
**24.06.2020  Bulletin 2020/26**

(51) Int Cl.:
**G06F 30/20** (2020.01)     **A23N 17/00** (2006.01)

(21) Application number: **19216923.3**

(22) Date of filing: **17.12.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **21.12.2018  NL 2022277**

(71) Applicant: **Trioliet Holding B.V.**
**7575 BW Oldenzaal (NL)**

(72) Inventor: **Liet, Robert Jan**
**7573 CS Oldenzaal (NL)**

(74) Representative: **De Vries & Metman**
**Overschiestraat 180**
**1062 XK Amsterdam (NL)**

(54) **METHODS FOR SIMULATING FODDER MIXING**

(57)    This disclosure relates to a computer-implemented method for simulating a mixing process of mixing fodder in a fodder mixing device. The fodder comprises at least a first fodder component and a second fodder component. The method comprises storing virtual representations of particles and surfaces and repeatedly performing a sequence of steps, the sequence comprising updating representation defining positions of the particles. At least one of these performed sequences comprises determining an interaction force based on a distance between a first and second particle and based on a defined interaction and comprises determining that the interaction force, or a derived interaction force determined based on the interaction force, exceeds a threshold value and comprises, based on this determination, irrevocably nullifying the defined interaction.

Fig. 1

EP 3 671 523 A2

**Description**

**Field of the invention**

This disclosure relates to methods for simulating mixing at least a first fodder component and a second fodder component, in particular to such methods wherein a discrete particle method (DPM) or discrete element method (DEM) is executed. This disclosure further relates to methods for designing and manufacturing fodder mixing devices and to fodder mixing devices having been designed and manufactured using simulations disclosed herein. Also, this disclosure relates to a computer, computer program and computer-readable storage medium for performing simulations disclosed herein.

**Background**

Designing a fodder mixing device is not straightforward. A fodder mixing device should have good mixing capabilities so that it can produce a homogeneous mixture of various fodder components. A fodder mixture may be understood to be homogeneous when it has the same or similar proportions of its fodder components throughout the mixture. Such homogeneous mixture advantageously ensures that animals will consume the amount of each fodder component as intended by a farmer as opposed to the animals picking out only some of the fodder components. However, the mixing capabilities of a mixing device strongly depend on its design. Even small alterations to the shape of a mixing chamber can significantly improve or worsen the mixing capabilities of the device.

To add to the complexity, the optimal design differs for different types of fodder to be mixed. A mixing chamber for mixing grass and corn would need to have a different shape than a mixing chamber for mixing straw and brewers grain. As another example, a mixing chamber for mixing grass grown in France and corn would need to have a different shape than a mixing chamber for mixing grass grown in The Netherlands and corn. Grass grown in France and grass grown in The Netherlands may have different characteristics causing different mixing behaviour and may thus have to be considered as different types of fodder when designing a mixer. To summarize, a mixing device is preferably tailored to the specific fodder mixture that a farmer intends to feed to his animals. In case a farmer intends to use the same mixing device for two different mixtures, e.g. on one day for mixing hay, silage grass, corn, brewers grain and concentrates and on another day for mixing silage grass and corn, the design of the mixing device is preferably a compromise in the sense that it can be used for both mixtures. In such case, the design is likely not the optimal design for either one of the mixtures.

However, it would not be feasible to employ a trial-and-error approach in order to determine an optimal design for every fodder mixture or to determine an above-described compromise design, at least not in reasonable time, because this would entail building several mixing devices for each type of fodder mixture. Therefore, there is a need in the art for methods that enable to more easily design mixing devices for different types of fodder mixtures.

**Summary**

To that end, a computer-implemented method is disclosed for simulating a mixing process of mixing fodder in a fodder mixing device, such as a vertical fodder mixing device. The method comprises performing a sequence of steps, the sequence comprising steps (i) to (iv) explained below. The steps need not necessarily be performed in a particular order. The sequence may be understood to be part of a Discrete Element Method (DEM) or Discrete Particle Method (DPM). Step (i) comprises, based on one or more stored virtual representations of surfaces and based on one or more virtual representations of one or more fodder components, each virtual representation of a fodder component defining particles of a particular type as well as the particle's respective positions relative to a reference surface, determining a resultant force on each defined particle. Step (ii) comprises, for each particle, based on its determined resultant force, solving an equation of motion for determining a further position of each particle at a further time instance. Step (iii) comprises updating one or more stored fodder component representations comprising updating the respective positions of the particles to be the respective further positions of the particles. Step (iv) comprises updating a surface representation

n of one or more physical surfaces, the updated representation defining a further position of these one or more physical surfaces relative to the reference surface at a further time instance.

The fodder comprises at least a first fodder component and a second fodder component. The method comprises storing a first virtual representation of one or more surfaces that form a mixing chamber of the fodder mixing device. The method also comprises storing a second virtual representation of one or more surfaces that form a mixing actuator of the fodder mixing device, the second virtual representation defining a position, and optionally a speed, of the mixing actuator relative to the mixing chamber. The method also comprises storing a third virtual representation of the first fodder component, the third representation defining particles of a first type and their respective positions relative to the mixing chamber and defining an interaction between at least a first and second particle of the first type. The interaction defines a dependence of an interaction force between the first and second particle on a distance between the first and second particle, and optionally based on previously determined forces acting on these particles and/or optionally based on previously determined positions of these particles. These previously determined forces and/or positions may become relevant when hysteretic effects are involved. The method also comprises storing a fourth virtual representation of the second fodder component, the fourth representation defining particles of a second type and their respective positions relative to the mixing chamber. The method further comprises repeatedly performing the sequence of steps described above. Herein, the stored representations that are input into step (i) are the first, second, third and fourth representation. Further, the fodder component representations that are updated in step (iii) are the third and fourth representations. The representation that is updated in step (iv) is the second representation. The updated second representation defines a further position of the mixing actuator relative to the mixing chamber at a further time instance. At least one execution of the sequence comprises the following steps a, b and c. Step (a) comprises determining said interaction force based on a distance between the first and second particle and based on the defined interaction. Step (b) comprises determining that the interaction force, or a derived interaction force determined based on the interaction force, exceeds a threshold value. Optionally, the derived interaction force is determined based on at least one further interaction force as well, for example by summing the interaction force and the at least one further interaction force. Step (d) comprises, based on this determination, irrevocably nullifying the defined interaction.

Typically, a simulated interaction force between two particles may vanish and emerge again depending on whether the particles are close to each other or far apart. A type of interaction between two particles that defines a force that will always re-establish if the two particles approach each other will be referred to hereinafter as the first type of interaction. In contrast, the above-mentioned second type interaction between the first and second particle of the first type is irrevocably nullified. After the interaction has been nullified, it can no longer define any force between the first and second particle, even if the first and second particle virtually approach each other again after nullification. A type of irrevocably nullifiable interaction between two particles will hereinafter be referred to as the second type of interaction.

Advantageously, the method enables to simulate a specific mixing device that is mixing a fodder mixture comprising said at least two fodder components. The simulation yields for a plurality of time instances the respective positions of the particles as defined by the third and fourth representation, which represent the first and second fodder component respectively. Of course, if further fodder components are simulated in addition to the first and second fodder component, which further components would then be represented by further representations defining other particles, the simulation would yield for said plurality of time instances the positions of these other particles as well. These positions allow to assess whether or when the virtual mixture of particles of the first and second type becomes homogeneous. Hence, the method provides a realistic prediction of the mixing capabilities of any mixer device design in relation to any fodder mixture without having to build the actual mixing device and testing it. The method enables to test a large number of different designs for any specific fodder mixture in order to determine which design functions best for said specific mixture or, where appropriate, to determine which compromise design should be selected in view of several mixtures that the mixing device should be able to prepare. Hence, this method enables to improve designs of fodder mixing devices.

The irrevocable nullification of the defined interaction may be understood to represent the cutting of a fiber of fibrous material or any other type of physical connection that can be irrevocably broken. The first fodder component or any other fodder component may comprise fibrous material. Thus, a further advantage of the method is that it enables to simulate cutting of a fodder component consisting of fibrous material, such as grass or straw. In general, the irrevocably nullifiable interaction between two particles of the same type may represent a physical connection and the irrevocable nullification of the interaction may represent the cutting of this physical connection.

The virtual positions of the virtual elements may be defined relative to any virtual point in the simulated environment. Then still, the virtual positions of these elements should be understood to be defined relative to one of these elements.

The third representation of the first fodder component may define many interactions between particles, which interactions are similar to the interaction defined between the first and second particle in the sense that these interactions can be irrevocably nullified.

In one embodiment, at least one of the first and second virtual representation comprises a non-uniform rational basis spline (NURBS) representing at least one curved surface of said one or more surfaces.

Typically, in DPM simulations, a curved surface is represented by many relatively simple surfaces, such as triangles. Surface polygonising is a known method for generating an appropriate set of virtual surfaces that represents a curved surface. A well-known example of surface polygonising is surface triangulation, wherein an appropriate set of triangles is determined that represents a curved surface. Polygonising can be performed relatively fast. However an important drawback is that a resulting set of virtual surfaces does not accurately represent an actual curved surface. To add to this, when such a set of virtual surfaces is used to represent an actual curved surface in a DPM method, then for each virtual surface it has to be calculated whether and how the virtual surface interacts with one or more particles, which tremendously increases the computational load. This embodiment allows to represent a curved surface with only one NURBS, which allows to calculate the interactions between the curved surface and particles based on only one calculation involving the NURBS. Although this one calculation is more complex than the calculation of an interaction between a simplified virtual surface of a polygonised surface, the total computation load is still reduced. The use of NURBS is especially advantageous when they are used to represent complex curved surfaces.

Typically, determining a force acting on a particle, which force is caused by the particle contacting a surface, involves determining the distance between the particle and the surface. In case the virtual representation comprises a NURBS, minimization algorithms may be used to determine this distance. Another example of how such distance may be determined is given by Chen, X.-D.; Yong, J.-H.; Wang, G.; Paul, G.-C.; Xu, G. Computing the minimum distance between a point and a NURBS curve. Comput. Aided Des. 2008, 40, 1051-1054.

One distinct aspect of this disclosure relates to a computer-implemented method for method for simulating a mixing process of mixing fodder in a fodder mixing device, such as a vertical fodder mixing device, the fodder comprising at least a first fodder component and a second fodder component. The first and/or second fodder component may comprise fibrous material. In this distinct aspect, the method comprises storing a first virtual representation of one or more surfaces that form a mixing chamber of the fodder mixing device; and storing a second virtual representation of one or more surfaces that form a mixing actuator of the fodder mixing device, the second virtual representation defining a position of the mixing actuator relative to the mixing chamber; and storing a third virtual representation of the first fodder component, the third representation defining particles of a first type and their respective positions relative to the mixing chamber; and storing a fourth virtual representation of the second fodder component, the fourth representation defining particles of a second type and their respective positions relative to the mixing chamber; the method comprising repeatedly performing a sequence of steps, the sequence comprising steps i-iv:

(i) based on the stored representations, determining a resultant force on each defined particle,
(ii) for each particle, based on its determined resultant force, solving an equation of motion for determining a further position of each particle at a further time instance;
(iii) updating the stored third and fourth representation comprising updating the respective positions of the particles to be the respective further positions of the particles;
(iv) updating the second representation, the updated second representation defining a further position of the mixing actuator relative to the mixing chamber at a further time instance.

In this distinct aspect of the method, at least one of the first and second virtual representation comprises a non-uniform rational basis spline (NURBS) representing at least one curved surface of said one or more surfaces. Thus, in this distinct aspect of the method, the determination of the interaction between particles of the first type and the nullification of this interaction based on a threshold value are optional features.

In one embodiment, the method comprises storing a further interaction, which may be understood to be an interaction of the first type referred to above. The further interaction defines a dependence of a further interaction force between the first and second particle on a distance between the first and second particle. Typically, such a further interaction is defined generally for all particle pairs in the sense that it defines a dependence of the further interaction force between any two defined particles representing any type of fodder, thus between the first and second particle, but also between two particles of any type. In this embodiment, determining the resultant force on the first particle comprises determining said further interaction force between the first and second particle based on the further interaction and on the distance between the first and second particle.

In one embodiment, the method comprises determining the resultant force based on the interaction force and on the further interaction force, e.g. by adding up the interaction force and the further interaction force. Additions of forces as described herein may be vector additions.

Contact models known in the art may be used to define said interaction and/or said further interaction(s) between particles, for example any of the contact models disclosed in publication "Luding, S., Rivas Abud, N., & Weinhart, T. (2017). From soft and hard particle simulations to continuum theory for granular flows. In S. Luding, G. Combe, & K. Taghizadeh (Eds.), ALERT Doctoral School 2017: Discrete Element Modeling (pp. 3-42)", hereinafter referred to as "Luding".

A contact model may be understood to define an interaction between a particle and another particle or surface. Such defined interaction may be a short-range interaction or a long-range interaction, such as a Coulomb interaction in case charged particles are involved. An interaction, also referred to as a force rule, may be understood to define a force acting on a particle in dependence of a distance between the particle and the other particle or surface. Furthermore, an interaction may define a force acting on a particle in dependence of at least one of

- respective orientations of the particles or surfaces that are involved,
- respective angular velocities of the particles that are involved,
- respective velocities of the particles involved.

In one embodiment, the method comprises storing a plurality of such further interactions. Then, the derived interaction force and/or the resultant force may be determined based on the plurality of further interaction forces, e.g. by adding up the interaction force and all further interaction forces.

In one example, the above-mentioned derived interaction force is determined on the basis of the interaction force and the above mentioned further interaction force, e.g. determined by summing the interaction force and the further interaction force.

In one embodiment, the method comprises storing a surface interaction defining a dependence of a surface interaction force between a surface and the first particle on a distance between the first particle and the surface. This embodiment further comprises determining the surface interaction force between the first particle and the surface based on the defined surface interaction and based on a distance between the first particle and the surface and comprises determining the resultant force on the first particle based on the interaction force and the surface interaction force, e.g. by adding up the interaction force and the surface interaction force.

The surface interaction may be defined generally in the sense that it defines a dependence of the surface interaction force between the surface and any particle, thus also between the surface and the first particle.

In one example, one contact model is used to generally define the further interactions of the first type and the surface interactions, also of the first type.

In one embodiment, determining a resultant force on each particle comprises, for each particle, using at least one contact model in order to determine at least one interaction force acting on the particle, wherein the interaction force is caused by an interaction of the particle with another particle or surface. Optionally, determining the resultant force further comprises determining, for each particle, at least one further body force acting on the particle, e.g. caused by gravity. Then, determining the resultant force on a particle comprises adding the determined interaction force, further interaction forces the at least one further body force and, where applicable, a determined surface interaction force.

In one example, the above-mentioned derived interaction force is determined on the basis of the interaction force and on the surface interaction force and optionally on the further interaction force, e.g. determined by summing these forces.

In one embodiment, the third representation defines at least one particle parameter for the particles of the first type, wherein the particle parameter has been determined based on a calibration experiment involving the first fodder component and based on a simulation of the calibration experiment involving a representation of the first fodder component. The calibration experiment comprises subjecting an amount of the first fodder component to a manipulation and measuring a bulk response of said amount of first fodder component to the manipulation. Further, determination of the at least one particle parameter comprises selecting the at least one particle parameter such that the simulated response of the representation of the first fodder component resembles the response measured during the calibration experiment.

This embodiment enables a convenient manner to calibrate the particle parameters. Advantageously, this embodiment obviates the need to test microscopic characteristics, such as a spring constant or tensile strength, of elements constituting the first fodder component in order to determine the particle parameters. Instead, the particle parameters are chosen such that the bulk response of the first fodder component is accurately simulated. As a result, the simulated bulk behavior of the particles of the first type in the simulated mixing process will accurately predict the bulk behavior of the first fodder component when it is being mixed with another fodder component.

The at least one particle parameter may be understood to be a particle parameter that is common to all particles of the first type.

Typically, the third and/or fourth virtual representation defines about 60 particle parameters.

In one embodiment, the simulation of the calibration experiment comprises storing a fifth representation of one or more surfaces of an apparatus used for subjecting the first fodder component to the manipulation. This embodiment further comprises storing a sixth representation of the first fodder component, the sixth representation defining the particles of the first type and their respective positions relative to said apparatus and defining at least one provisional particle parameter for the particles of the first type. This embodiment further comprises repeatedly performing the above described sequence of steps using as input the fifth representation and sixth representation. The determination of the at least one particle parameter for the third representation then comprises adjusting the sixth representation comprising adjusting the at least one provisional particle parameter, repeating the simulation using the adjusted sixth representation, and, based on a determination that the simulated response resembles the response measured during the calibration experiment, selecting the adjusted at least one provisional particle parameter as said at least one particle parameter defined by the third representation. This embodiment advantageously makes use of a discrete particle method (DPM) or discrete element method (DEM) for accurately simulating the calibration experiments. This embodiment may be understood to use DPM or DEM to predict the outcome of a calibration experiment and if the outcome deviates from the predicted outcome, then the simulation is adjusted, in particular the particle parameters are adjusted.

In one embodiment, the calibration experiment comprises inserting an amount of the first fodder component into a rotatable drum, rotating the drum and measuring the response of the amount of the first fodder component in response to the rotation of the drum.

In one embodiment, the calibration experiment comprises applying a compressive force to an amount of the first fodder component, and measuring the compression of the amount in response to the compressive force.

In one embodiment, the calibration experiment comprises, after applying a compressive force to an amount of the first fodder component, measuring the extent to which the first fodder component springs back.

In one embodiment, the calibration experiment comprises, applying a compressive force to an amount of the first fodder component, the first fodder component being arranged in a cylinder, and measuring the force that is exerted by the first fodder component onto one or more walls of the cylinder during compression. This embodiment may comprise measuring the compressive force and measuring a base force that is exerted, due to the compression, by the fodder component onto a base surface of the cylinder that is separate from the one or more walls of the cylinder and subtracting the further force from the compressive force in order to determine the force exerted by the first fodder component onto one or more walls of the cylinder.

In one embodiment, the calibration experiment comprises shearing an amount of fodder with an object, such as a blade, the object having a predetermined velocity at the moment of impact, and measuring an energy that is required for cutting through the amount of fodder with said object.

This disclosure may be understood to, in respective distinct aspects, relate to respective methods of performing the respective calibration experiments as described herein.

In one embodiment, the first fodder component consists of elements and a simulated ratio between a size of the particles of the first type defined by the third representation and a size of the mixing chamber as represented by the first representation is larger than an actual ratio of a size of elements constituting the first fodder component and a size of the actual mixing chamber.

DPM simulations typically have a complexity of $N^2$, wherein N denotes the number of simulated particles. In this embodiment, the number of simulated particles are reduced.

One aspect of this disclosure relates to a computer program or suite of computer programs comprising at least one software code portion or a computer program product storing at least one software code portion, the software code portion, when run on a computer system, being configured for executing one or more of the method steps as described herein.

One aspect of this disclosure relates to a method for manufacturing a fodder mixing device comprising designing a fodder mixing device comprising a mixing chamber and a mixing actuator for mixing at least the first and second fodder component. The designing comprises steps v-vii:

> (v) for a first provisional design of the fodder mixing device, performing the computer-implemented method as described herein,
> (vi) for a second provisional design of the fodder mixing device different from the first design, performing the computer-implemented method as described herein,
> (vii) based on a determination that the second provisional design is associated with better simulation results, selecting the second provisional design as design for the fodder mixing device. The manufacturing method further comprises manufacturing the fodder mixing device in accordance with the selected design.

A simulation result may be characterized by performance parameters, which may be output as part of the computer-implemented method. A simulation result for example relates to a degree of mixing of particles of the first and second type and/or to an amount of the work performed by the simulated actuator and/or to a maximum force on the actuator and/or to how long it takes before a degree of mixing reaches a certain value, et cetera.

One aspect of this disclosure relates to a fodder mixing device obtained by manufacturing methods described herein.

One aspect of this disclosure relates to a rotatable drum configured to hold fodder and manipulate the fodder by rotating. The rotatable drum has a diameter of at least 0.5 meter, preferably of at least 1.2 meter, which allows a fodder component under test to consist of elements having a size larger than one millimeter, preferably larger than 5 millimeter, more preferably larger than 1 centimeter. Preferably, one of the side walls of the rotating drum is transparent so that the response of the first fodder component to the rotation of the drum can be easily measured. Preferably, the rotatable drum has a width of at least 0.3 meter, more preferably of at least 0.5 meter.

One aspect of this disclosure relates to an apparatus for performing the compression test. The apparatus comprises a force application system for exerting a compressive force on an amount of fodder component, and a compression measurement system for measuring a compression of the fodder component and/or a force measurement system for measuring the force exerted on the fodder component by the force application system. This apparatus may further comprise a cylinder having one or more side walls and a base surface separate from the side walls, wherein the base surface is separate from the side walls and wherein the apparatus is configured to measure the force that is exerted by the amount of compressed fodder component onto the based surface.

One aspect of this disclosure relates to an apparatus for performing a calibration experiment, the apparatus comprising a fodder holding device for holding an amount of fodder, and an impacting device, optionally comprising a blade, and an impact generating system for causing the impacting device to shear the amount of fodder component in the fodder holding device with a predetermined velocity.

One aspect of this disclosure relates to a non-transitory computer-readable storage medium storing at least one software code portion, the software code portion, when executed or processed by a computer, is configured to perform one or more steps of the methods disclosed herein.

One aspect of this disclosure relates to a computer comprising a computer readable storage medium having computer readable program code embodied therewith, and a processor, preferably a microprocessor, coupled to the computer readable storage medium, wherein responsive to executing the computer readable program code, the processor is configured to one or more steps of the methods described herein.

As will be appreciated by one skilled in the art, aspects of the present invention may be embodied as a system, a method or a computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Functions described in this disclosure may be implemented as an algorithm executed by a processor/microprocessor of a computer. Furthermore, aspects of the present invention may take the form of a computer program product embodied in one or more computer readable medium(s) having computer readable program code embodied, e.g., stored, thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples of a computer readable storage medium may include, but are not limited to, the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of the present invention, a computer readable storage medium may be any tangible medium that can contain, or store, a program for use by or in connection with an instruction execution system, apparatus, or device.

A computer readable signal medium may include a propagated data signal with computer readable program code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

Program code embodied on a computer readable medium may be transmitted using any appropriate medium, including but not limited to wireless, wireline, optical fiber, cable, RF, etc., or any suitable combination of the foregoing. Computer program code for carrying out operations for aspects of the present invention may be written in any combination of one or more programming languages, including an object oriented programming language such as Java(TM), Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer, or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described below with reference to flowchart illustrations and/or block diagrams of methods, apparatus (systems), and computer program products according to embodiments of the present invention. It will be understood that each block of the flowchart illustrations and/or block diagrams, and combinations of blocks in the flowchart illustrations and/or block diagrams, can be implemented by computer program instructions. These computer program instructions may be provided to a processor, in particular a microprocessor or a central processing unit (CPU), of a general purpose computer, special purpose computer, or other programmable data processing apparatus to produce a machine, such that the instructions, which execute via the processor of the computer, other programmable data processing apparatus, or other devices create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

The flowchart and block diagrams in the figures illustrate the architecture, functionality, and operation of possible implementations of systems, methods and computer program products according to various embodiments of the present invention. In this regard, each block in the flowchart or block diagrams may represent a module, segment, or portion of code, which comprises one or more executable instructions for implementing the specified logical function(s). It should also be noted that, in some alternative implementations, the functions noted in the blocks may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustrations, and combinations of blocks in the block diagrams and/or flowchart illustrations, can be implemented by special purpose hardware-based systems that perform the specified functions or acts, or combinations of special purpose hardware and computer instructions.

Moreover, a computer program for carrying out the methods described herein, as well as a non-transitory computer readable storage-medium storing the computer program are provided. A computer program may, for example, be downloaded (updated) to the existing computer systems or be stored upon manufacturing of these systems.

Elements and aspects discussed for or in relation with a particular embodiment may be suitably combined with elements and aspects of other embodiments, unless explicitly stated otherwise. Embodiments of the present invention will be further illustrated with reference to the attached drawings, which schematically will show embodiments according to the invention. It will be understood that the present invention is not in any way restricted to these specific embodiments.

**Brief description of the drawings**

Aspects of the invention will be explained in greater detail by reference to exemplary embodiments shown in the drawings, in which:

FIG. 1 is a flow chart illustrating an embodiment of the method for simulating a mixing process;
FIG. 2 visualizes virtual representations used in an embodiment;
FIG. 3 illustrates parameters that may be involved in the definition of an interaction;
FIG. 4 visualizes a first and a second type of interaction between two particles;
FIG. 5 is a flow chart illustrating an embodiment of the method;
FIG. 6 schematically illustrates a calibration experiment and simulations of such experiment;
FIG. 7 illustrates a rotatable drum according to an embodiment for performing a calibration experiment;
FIG. 8 illustrates an apparatus according to an embodiment for performing a compression test;
FIG. 9 illustrates an apparatus according to an embodiment for performing an impact test;
FIG. 10 illustrates a data processing system according to an embodiment.

**Detailed description of the drawings**

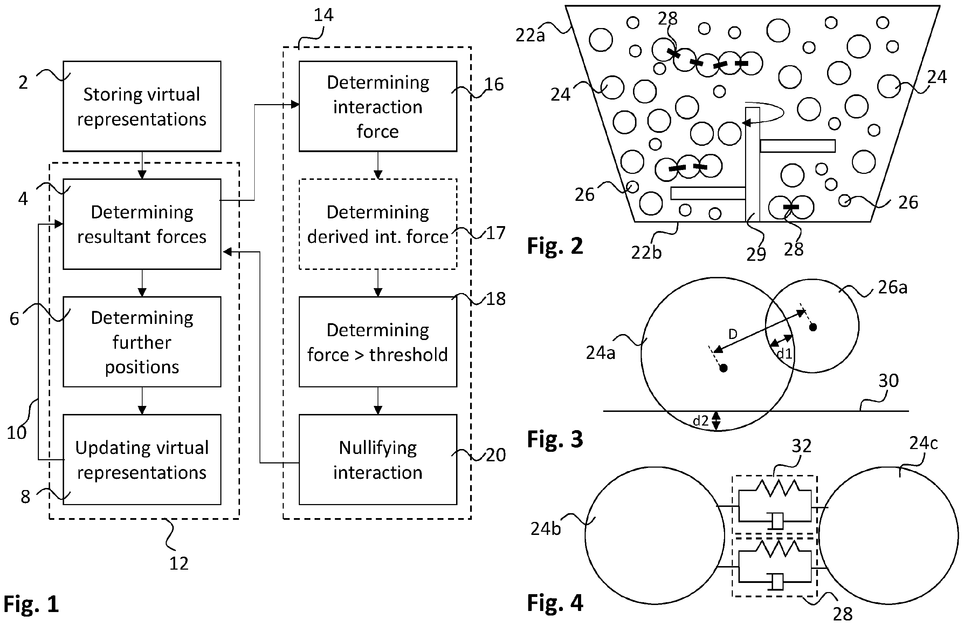

FIG. 1 depicts method steps according to an embodiment of the computer-implemented method. Step 2 of FIG. 1 comprises storing the virtual representations that are input into the simulation. In particular, step 2 comprises storing the first virtual representation of one or more surfaces forming the mixing chamber of a fodder mixing device, the second virtual representation of one or more surfaces forming a mixing actuator of the fodder mixing device, the third virtual representation of the first fodder component and the fourth virtual representation of the second fodder component. Examples of fodder components are straw, hay, grass, cereals, minerals, potatoes, proteins, wet by-products, brewers grain, et cetera.

A virtual representation defining particles or, respectively, a virtual representation of a surface may in particular define particle parameters for each particle or, respectively, surface parameters for the surface, such as

- one or more position parameters indicating a position of the particle or surface; and
- a mass parameter indicative of a mass of the particle or surface, and
- a dimension parameter indicative of a dimension of the particle, such as radius of a spherical particle, or of a dimension of the surface; and
- a stiffness parameter indicative of a stiffness of the particle or surface; and
- a velocity parameter indicative of a velocity of the particle or surface; and
- an angular velocity parameter indicative of an angular velocity of the particle or surface; and
- an orientation parameter indicative of an orientation of the particle or surface.

FIG. 2 visualizes the first, second, third and fourth virtual representation. The one or more surfaces forming the mixing chamber are indicated by 22. In this example, the one or more surfaces comprise an upright surface 22a and a ground surface 22b. In principle, the simulated mixing chamber, and thus the surfaces forming the mixing chamber, may have any desired shape or form. The one or more surfaces of the mixing actuator are indicated by 29. The actuator may be understood to be the parts of the fodder mixing device that are movable with respect to the mixing chamber in order to mix different fodder components. Typically, the actuator comprises a plurality of cutting blades for cutting through the fodder, e.g. for cutting fibers of a fodder component, such as straw or grass. It should be appreciated that a mixing chamber may comprise a plurality of mixing actuators. In such case, the method would comprise storing a virtual representation of each of these mixing actuators. These virtual representation would then be processed similarly as the second virtual representation.

Particles 24 visualize the third representation defining the first type of particles. Each particle has a defined position within the mixing chamber. Further, the dashes 28 visualize respective interactions between two particles 24 of the first type. The interactions 28 are of the second type and may thus at some point be irrevocably nullified. The interactions 28 and the interaction forces respectively defined by these interactions 28 may be understood to represent the forces between two particles due to the two particles being neighboring parts of a fiber.

Particles 26 visualize the fourth representation defining the second type of particles. Again the particles 26 have a position within the mixing chamber.

The embodiment of the method further comprises a sequence of steps 12, which sequence comprises steps 4, 6 and 8. The sequence of steps 12 is repeatedly performed as indicated by arrow 10. Herein, repeatedly performed may be understood as that the sequence 12 is performed at least twice. Step 4 comprises determining for each defined particle, irrespective of whether it is defined by the third or fourth representation, a resultant force on the particle. This step may comprise, for each defined particle, using one or more contact models in order to determine forces acting on the particle. In an example, Hertzian contact models are used to determine the resultant force on a particle. A resultant force for a particle may simply be determined by adding up all forces that are acting on this particle.

Step 6 comprises, for each particle, solving equations of motions for determining a further position of each particle and step 8 comprises updating the positions of the particles to be the determined further positions. As such, the movements of the respective particles can be simulated. After the positions of the particles have been updated, step 4 is again performed only now the positions of the particles have been updated. As a result of the updated positions, the forces acting on the particles have also changed. Some particles may no longer contact each other, some particles may come into contact with new particles, some particles may no longer contact a surface and some particles may come into contact with a surface.

During at least one execution of sequence 12, the steps 16, 17, 18 and 20 are performed. Possibly, these steps are performed as part of step 4 described above. Step 16 comprises determining, based on a second type interaction, an interaction force between a first and second particle of the first type.

Step 17 is an optional step and comprises determining a derived interaction force between the first and second particle based on the determined interaction force. Typically, further interactions, e.g. further first type interactions, are also defined between the first and second particle, giving rise to further interaction forces that are taken into account when determining whether the interaction used in step 16 is to be nullified or not. In one example, step 17 comprises adding these further interaction forces to the interaction force determined in step 16 in order to arrive at the derived interaction force.

Step 18 comprises determining that the interaction force, or, if determined, the derived interaction force, exceeds a threshold value. This threshold value may be prestored and may be defined specifically for the interaction between the first and second particle. Then, in step 20, based on the determination in step 18, the defined interaction between the first and second particle is nullified. As a result, this interaction no longer gives rise to an interaction force.

FIG. 3 visualizes parameters that may be involved in a defined interaction, in particular in a linear normal contact interaction and/or in an adhesive, elasto-plastic normal contact interaction. In FIG. 3, a particle 24a of the first type and a particle 26a of the second type have respective positions and radii such that the particles, which are typically defined as spheres, have an overlap $d_1$. Further, a surface 30 is positioned such that particle 24a and surface 30 have an overlap $d_2$. The interaction may be in accordance with equation [3] of Luding:

$$f = kd + \gamma_0 v_n,$$

wherein k is a stiffness constant of the interaction, d is an overlap between two particles, $\gamma_0$ is a viscous damping constant and $v_n$ is a relative velocity in normal direction. Then, based on overlap d1 and based on this interaction, the force on particle 24a from particle 26a can be determined.

Similarly, based on overlap d2 and based on a spring stiffness and viscous damping coefficient both associated with the contact between particle 24a and surface 30, the force on particle 24a from surface 30 can be determined.

The defined interactions as described herein may be any, or any combination of, the interactions that are respectively defined in equations [3], [6], [9], [22] of Luding.

Other parameters that may be used to define an interaction are listed in table 1 of Luding. Parameter D for example indicates the distance between the two midpoints of the respective particles.

FIG. 4 visualizes an interaction 32 of the first type and an interaction 28 of the second type between two particles 24b, 24c of the first type. Both interactions are indicated as a spring-dashpot interactions. It should be appreciated that both interactions may be defined using contact models known in the art, e.g. as disclosed in Luding. However, importantly if an interaction force between the two particles becomes too large, the interaction 28 may be nullified. As a result, this interaction 28 can no longer give rise to an interaction force that can contribute to a total force on a particle. Both interaction 32 and non-nullified interaction 28 in principle give rise to respective interaction forces that can contribute to a resultant force on a particle.

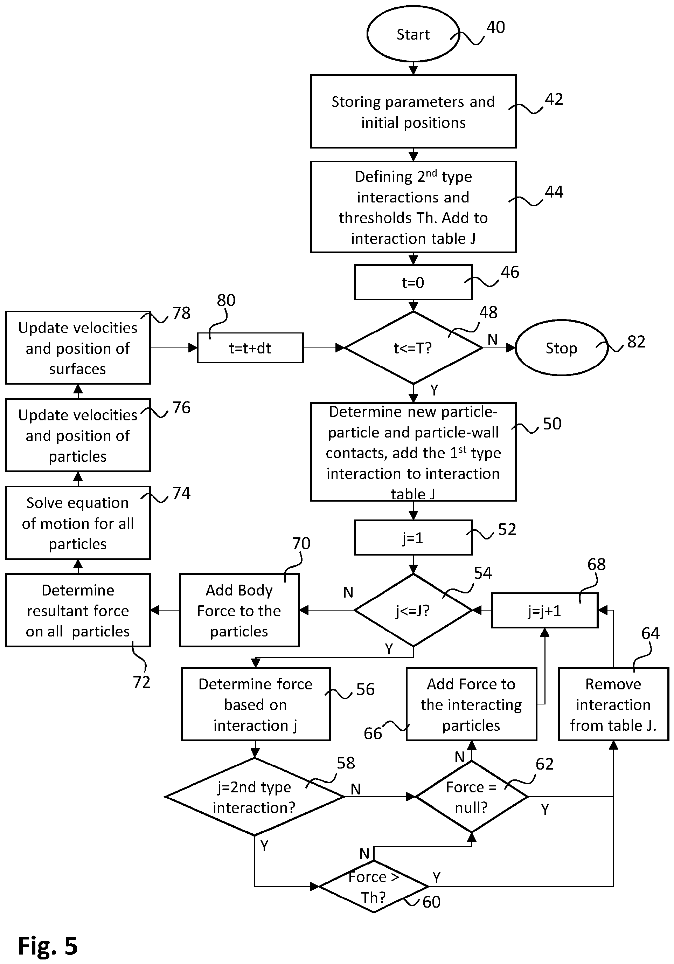

FIG. 5 is a flow diagram illustrating an embodiment of the computer-implemented method as described herein. The simulation method starts at step 40. Then, in steps 42 and 44 the virtual representations are stored. In step 42, the positions and parameters of all particles are stored. In this step, the total number of particles N that are to be simulated may be determined. The particles may be numbered {1, 2, 3, ..., N-1, N} and each particle may thus be identified by its particle number n. Typically a user can input how much of the mixing chamber should be occupied by particles during the simulation. Typically this would lead to approximately one million particles being involved in the simulation. In step 42, also the positions and parameters of all surfaces, both of the mixing chamber and of the mixing actuator, can be determined. Preferably, a speed of the mixing actuator is also determined. Step 44 comprises defining for a number of pairs consisting of two particles of the first type an interaction of the second type. Typically, such an interaction is defined for many particle pairs. As also shown in FIG. 2, particles may be concatenated to each other in the sense that for one particle two of such interaction 28 can be defined for two respective neighbouring particles. All second-type interactions that are defined step 44 are added to a so-called interaction table J, which will be explained in more detail below.

Furthermore, in any of the steps 42 and 44, a total time T may be defined, which indicates the total time duration that is to be simulated. In step 46, a time parameter t is set to zero. The simulation will continue until the time parameter t exceeds time T and step 48 ensures that the simulation is stopped (step 82) if the time parameter t exceeds the maximum time T. In an example, the time T is fifteen minutes. Fig. 5 shows that if the time parameter t is lower or equal to time T, step 50 is performed.

Step 50 comprises determining which new particle-particle contacts are present in the virtual environment at time t and adding for each of these particle-particle contacts a first-type interaction to the interaction table J. It should be appreciated that these particle-particle contacts may involve any type of particle, for example may involve a contact between two particles of the same type, or a contact between two particles of different type. Furthermore, step 50 comprises determining which particle-surface contacts are present in the virtual environment at time t and adding for each of these new particle-surface contacts a first-type interaction to the interaction table J. Thus, after step 50, each interaction that is stored in table J is associated with a particle-particle pair or with a surface-particle pair. Table J should be understood to comprise in total J interactions that are numbered {1, 2, ..., J-1, J}. The table below shows part of an exemplary interaction table J.

| j | particle A | particle B | surface | interaction type | interaction |
|---|---|---|---|---|---|
| 1 | 1 (first type) | 2 (first type) | | first | $f^1 = k^1 d^1 + \gamma_0 v_n^1$ |
| 2 | 1 (first type) | 2 (first type) | | second | $f^2 = k^1 d^1 + \gamma_0 v_n^1$ |
| 3 | 1 (first type) | 3 (second type) | | first | $f^3 = k^3 d^3 + \gamma_0 v_n^3$ |
| 4 | 2 (first type) | | sidewall A | first | $f^4 = k^4 d^4 + \gamma_0 v_n^4$ |
| 5 | 5 (first type) | 3 (second type) | | first | $f^5 = k^3 d^5 + \gamma_0 v_n^5$ |
| 6 | 3 (first type) | | actuator wall B | first | $f^6 = k^5 d^6 + \gamma_0 v_n^6$ |

(continued)

| j | particle A | particle B | surface | interaction type | interaction |
|---|---|---|---|---|---|
| 7 | 2 (first type) | 4 (first type) | | second | $f^7 = k^1 d^7 + \gamma_0 v_n^7$ |

The above table shows seven interactions. Interaction 1 is based on a contact between particle 1 of the first type and particle 2 of the first type. The table shows that this interaction involves a constant $k_1$ and uses an overlap $d_1$ between the bodies of the first and second particle. Interaction 2 is an interaction of the second type that is defined for particles 1 and 2. Interaction 3 is based on a contact between particle 1 and particle 3 that is of the second type. Therefore, the stiffness constant used in this interaction is different, namely $k_3$. Note that interaction 5, based on a contact between two particles of respectively the first and second type, just as interaction 2, also comprises the stiffness constant $k_2$. Furthermore, interactions 4 and 6 are based on particle-surface contacts.

It should be appreciated that the parameter values, such as $k_1$, that are used in an interaction may be an average of two parameter values of the respective particles, or respectively of a particle and a surface, for which the interaction is defined. To illustrate, a first stiffness constant $k_A$ may have been determined for particles of the first type and a second stiffness constant $k_B$ may have been determined particles of the second type. Optionally these may have been determined on the basis of calibration experiments as described herein. Then, a stiffness constant that is used in an interaction between a particle of the first type and a particle of the second type, such as $k_3$ above, may then be calculated as an average of $k_A$ and $k_B$, for example as $k_3 = (k_A + k_B) / 2$. Other parameters than the stiffness parameter may be determined similarly.

Then, in step 52 a counter parameter j is set to an initial value, such as 0 or 1. Step 54 ensures that a sequence of steps is performed for all interactions in table J. As long as j is equal to or below the total number J of interactions, step 56 will be performed after step 54. Step 56 comprises determining a force based on interaction j. Typically, the interaction defines a force between two particles based on a distance between the two particles or a force between a surface and a particle based on a distance between the particle and the surface. Determining the force in step 56 thus typically comprises determining a distance based on the virtual representations defining the involved particles and/or surface, which virtual representations define the positions of the involved particles and/or surface. Furthermore, a velocity of the particles and surfaces may also be involved in the determination of the force as well as hysteretic effects.

In step 58, it is checked whether the interaction j is a second type of interaction or not. If this is the case, then step 60 is performed. If the interaction force determined in step 58 exceeds the threshold value, step 64 is performed which comprises removing interaction j from table J. With this removal, the second-type interaction j is herewith to be understood to be irrevocably nullified for the rest of the simulation. After all, only in step 44 are interactions of the second type defined and step 44 will not be performed again during the remainder of the simulation.

If the force is determined in step 60 to not exceed the threshold value, then step 62 is performed, which is described below.

If it is determined in step 58 that j is not a second-type of interaction, it is subsequently checked in step 62 whether the force is null. If this is the case, then the interaction is also removed from table J in step 64. Thus, in an example, a first-type of interaction is defined for a particular set of two particles that is removed in step 64. However, this should not be understood as an irrevocable nullification. After all, step 50 will be performed again for a further time instance and step 50 comprises determining the contacts between particles and surfaces and determining the interactions of the first type associated with these contacts. Subsequently, these interactions are added to table J. Therefore, with reference to the above table, in one example, interaction 1, involving particle 1 and particle 2, may be removed at some point from table J, because the force that is determined based on interaction 1 is null. Then, for a later time instance, step 50 is performed again in which it is determined that particles 1 and 2 contact each other again. As a result, interaction 1 will be added again to table J.

If the force determined in step 58 is not null, then this force is added to the involved particle or particles, the former being the case if the interaction is a particle-surface interaction and the latter being the case if the interaction is a particle-particle interaction. After step 66, the counter j is incremented by 1 in step 68.

After the loop comprising steps 56 and 68 has been performed for all defined interactions in interaction table J, one or more forces have been determined for each particle in the simulation. Continuing the above example, forces $f_1$, $f_2$ and $f_3$ will have been determined for particle 1, forces $f_1$, $f_2$, $f_4$ and $f_7$ for particle 2, forces $f_3$, $f_5$, $f_6$ for particle 3, force $f_7$ for particle 4 and force $f_5$ for particle 5.

Then, in step 70, a body force is determined for each particle. Typically the body force is the gravitational force.

Step 72 comprises determining a resultant force for each particle, e.g. by adding all forces together that have been determined for the particle. Then, in step 74, an equation of motion is solved for every particle, based on which further positions and velocities can be determined. Step 74 may comprise performing a Verlet integration known in the art. Step 76 comprises updating the velocities and positions of the particles to be the positions and velocities determined in step 74. The positions of the particles may be updated in the sense that the determined further positions replace the previous positions of the particles. Preferably, the determined new positions are stored in association with the time t. At the end of the simulation the respective positions for all particles will then have been stored for a plurality of time instances. In step 78, the representation of at least the surfaces of the mixing actuator is also updated, in particular the positions and/or velocity of surfaces of the mixing actuator is updated, in order to reflect a movement of the actuator. The movement of the mixing actuator may be pre-programmed.

In step 80, the time is increased by dt, typically dt has a value of $t_c/50$, wherein $t_c$ may be defined by equation 4 of Luding. Once the time t exceeds time T, the method stops in step 82.

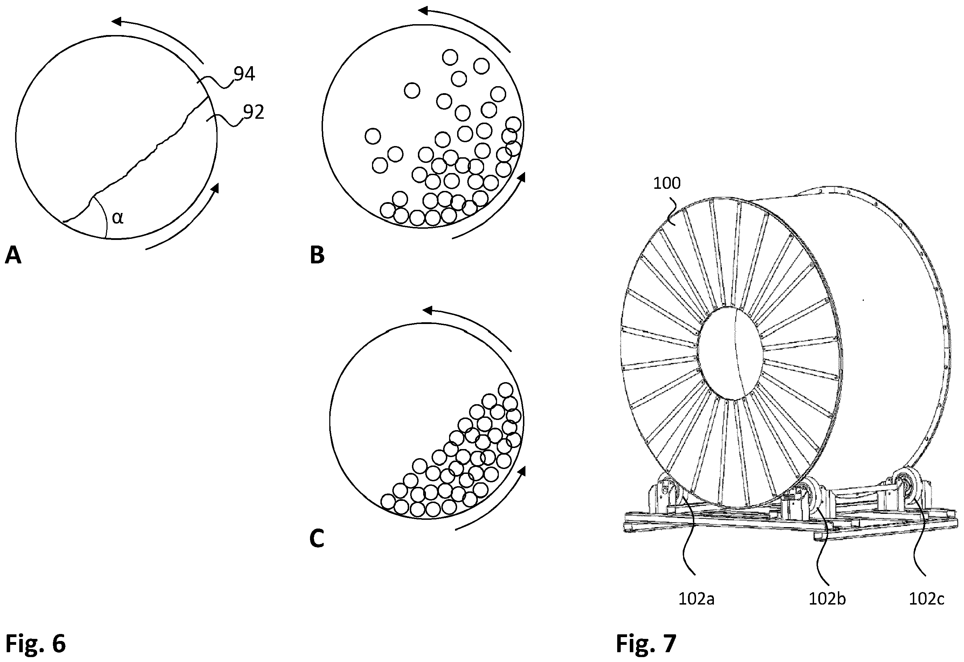

FIG. 6 illustrates how one or more particle parameters as defined by a virtual representation may be determined. Determining these parameters may involve performing an actual calibration experiment, such as a rolling drum experiment. To this end, an amount 92 of the actual fodder component that is to be virtually represented is subjected to a manipulation and subsequently, the bulk response of this amount is measured.

In an example, the amount of fodder component 92 is inserted into a rotatable drum 94 and the manipulation comprises rotating the drum 94. Then, an angle of inclination alpha may be measured of the material in dependence of a rotational speed of the drum. Additionally or alternatively, the bulk response may be measured in the sense that a rotational speed is measured at which the material flow will be centrifugal, i.e. at which the amount of fodder component forms a ring on the peripheral of the drum.

Figure 6A illustrates an actual calibration experiment wherein the drum has a certain rotational velocity. After a certain time, a steady state has been reached and the angle of inclination is alpha.

Figure 6B visualizes a first simulation of the same calibration experiment, at said certain time, and wherein the drum is simulated to rotate at said rotational velocity. For this first simulation, a particle parameter, such as a stiffness parameter indicating a stiffness of the particles, is set to a value of 10 (arbitrary units). Clearly, the bulk response that is observed in the simulation differs from the actual bulk response of the actual experiment.

Figure 6C visualizes a second simulation of the same calibration experiment. The second simulation is identical to the first simulation with the exception that the stiffness parameters for the particles is set to a value of 2 (arbitrary units). As a result, the bulk response of the simulated particles is similar to the bulk response of the actual fodder. In this example, the inclination angle of the first particles is similar to the inclination angle alpha that was observed in the actual calibration experiment.

Thus, a particle parameter need not involve actually measuring the microscopic parameter of an actual particle of the fodder component, e.g. need not involve actually measuring a stiffness of a blade of grass. Conveniently, the particle parameters need only be selected such that the simulated bulk response measures an actual bulk response of the fodder component. Preferably, such calibration experiments are performed separately for each fodder component.

Respective examples of bulk responses are sliding, slumping, avalanching, continuous avalanching, cascading and centrifuging of the particles.

FIG. 6 is also meant to illustrate that the ratio between a size of simulated particles and a rotating drum or mixing chamber can be much larger than the ratio between an actual size of an element constituting a fodder component and the actual size of the rotating drum or mixing chamber respectively. This allows to greatly reduce the number of particles that need to be simulated and thus greatly reduce the computational power that is required for performing a simulation.

FIG. 7 illustrates a rotatable drum that may be used for performing calibration experiments as described herein. Preferably, the rotatable drum has at least one transparent side wall so that the bulk response of the measured material can be conveniently measured. Furthermore, the inner surface of the drum may comprise, e.g be at least partly covered with, rough material, such as steel strips or angled or U-shaped bars, so that the measured fodder will be swept along with the moving inner surface of the drum. Preferably, the drum has a diameter of at least 0.5 meter, more preferably of at least 1.2 meter. This would namely render the drum suitable for manipulating a sufficient amount of fodder. During a calibration experiment with the rotatable drum, typically less than 50% of the drum, such as 40%, of the drum will be filled with material. The rotatable drum as shown in figure 7 comprises means 102 for rotating the drum.

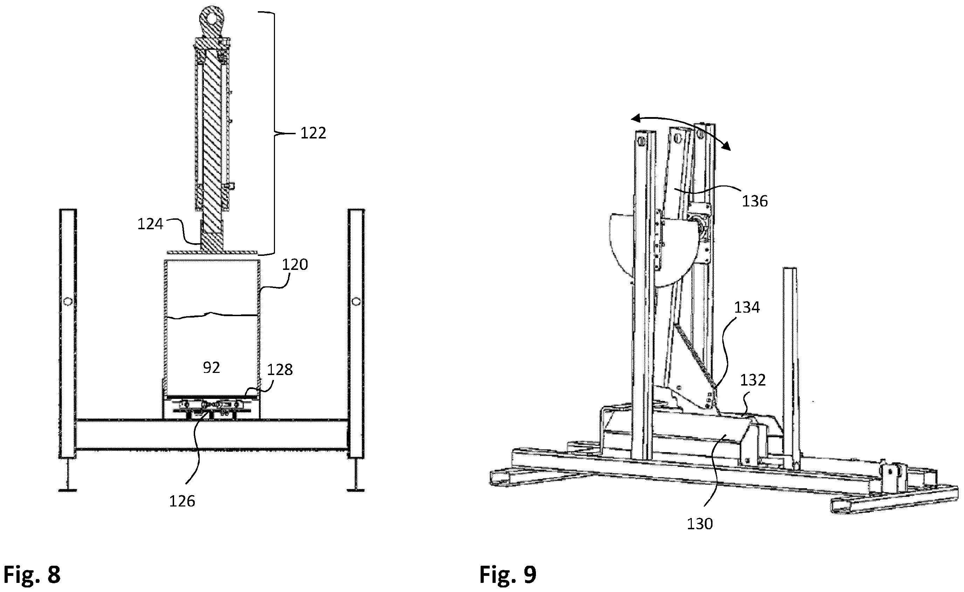

FIG. 8 illustrates an apparatus for performing a compression test, which is another type of calibration experiment that may be performed for determining particle parameters. In this test, an actual amount of a fodder component 92 may be inserted into a tube 120. Then, the material 92 will be compressed in a controlled manner, for example in the sense that a known pressure is applied to the material.

The apparatus comprises means for applying a pressure to the fodder component 92. In the depicted example, these means comprise an hydraulic cylinder 122. How far the piston extends, e.g. extends into the cylinder, then indicates how much the fodder component is compressed.

The apparatus thus comprises means for measuring a compression of the fodder component, such as means for measuring the extension of a piston of an hydraulic cylinder as described above. Advantageously, because the fodder component is compressed in a tube having a uniform cross section, the height of the fodder component is an indication of the volume of and thus of the compression of the fodder component 92. In particular a tube having a circular uniform cross section is advantageous, because then the forces interacting between side wall of the tube and fodder component are distributed uniformly.

Additionally or alternatively, the apparatus comprises means for measuring the pressure and/or force that is applied to the fodder component. The depicted apparatus comprises one or more pressure sensors 126 for measuring the total force on a base surface 128 of the apparatus. Preferably, the base surface is separated from the side walls of the cylinder 120 so that the force that is absorbed by the cylinder walls can be determined by subtracting the compression force from the force as measured by platform 126/128. The force absorbed by the cylinder walls is a useful parameter. In another example, not shown, the amount of pressure that is exerted by the hydraulic cylinder can be measured and/or controlled.

With these means, a relation between exerted pressure and volume of the amount 92 of fodder component can be obtained. Subsequent DPM simulation of such an experiment may then be performed in order to determine the particle parameters that cause the simulated bulk response of the fodder component to be similar to the actually measured bulk response during the simulation.

A preferred method for performing such a compression test comprises the following steps:

- Inserting the amount of fodder component 92 into the tube 120 comprising inserting the amount of fodder component in an auxiliary tube that can be inserted into the tube, inserting the auxiliary tube into the tube and lifting the auxiliary tube from the tube so that the amount of fodder component remains in the tube. With this method, it is prevented that differences in loading techniques distort measurements. Prior to inserting the amount of fodder component its weight is preferably measured.
- Moving the tube as to position it over the base surface 128 of the compression test, e.g. by sliding the tube over a rails.
- Compressing the amount of fodder component while measuring both an extension of the hydraulic cylinder's piston and the force that is exerted on the base surface 128, e.g. by using the pressure sensor(s) 126. In this step, either the exerted force may be controlled and the compression may be measured or the amount of compression may be controlled and the required force for this compression may be measured.

The compression test may be understood to yield the following data points:

- Hydraulic piston extension as a function of piston force
- Force exerted on the base surface as function of force exerted by the piston
- One of the above as a function of the speed with which the variables in the experiment are varied.
- Bulk density of the fodder component.
- Force that is required for removing the fodder component from the tube after the compression test.

These data may be stored for future reference, e.g. for comparison of data that was obtained for another fodder component. Similar results for two fodder components may indicate that these fodder components will behave similarly in a fodder mixing device and/or that they should have similar particle parameters when performing a simulation as described herein.

FIG. 9 illustrates another apparatus for performing a calibration experiment. In this experiment, an amount of fodder component is compressed into a cylinder 130 using a constant force. The cylinder has a slot 132 in an upper part of the cylinder. Then, a blade 134 having a predetermined velocity hits the fodder component that sits compressed in the cylinder through the slot. In one example, the blade is attached to a pendulum 136. The experiment comprises measuring the energy and/or shear force that is required to cut through the fodder material. If the blade gets stuck in the fodder component, then the experiment may involve measuring how far the blade has penetrated into the fodder component.

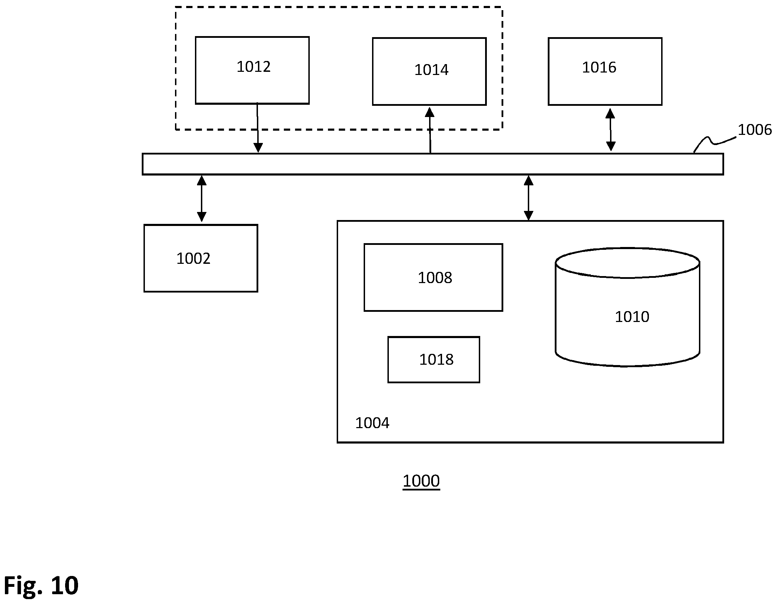

Fig. 10 depicts a block diagram illustrating an exemplary data processing system. As shown in Fig. 10, the data processing system 1000 may include at least one processor 1002 coupled to memory elements 1004 through a system bus 1006. As such, the data processing system may store program code within memory elements 1004. Further, the processor 1002 may execute the program code accessed from the memory elements 1004 via a system bus 1006. In one aspect, the data processing system may be implemented as a computer that is suitable for storing and/or executing program code. It should be appreciated, however, that the data processing system 1000 may be implemented in the form of any system including a processor and a memory that is capable of performing the functions described within this specification.

The memory elements 1004 may include one or more physical memory devices such as, for example, local memory 1008 and one or more bulk storage devices 1010. The local memory may refer to random access memory or other non-persistent memory device(s) generally used during actual execution of the program code. A bulk storage device may be implemented as a hard drive or other persistent data storage device. The processing system 1000 may also include one or more cache memories (not shown) that provide temporary storage of at least some program code in order to reduce the number of times program code must be retrieved from the bulk storage device 1010 during execution.

Input/output (I/O) devices depicted as an input device 1012 and an output device 1014 optionally can be coupled to the data processing system. Examples of input devices may include, but are not limited to, a keyboard, a pointing device such as a mouse, or the like. Examples of output devices may include, but are not limited to, a monitor or a display, speakers, or the like. Input and/or output devices may be coupled to the data processing system either directly or through intervening I/O controllers.

In an embodiment, the input and the output devices may be implemented as a combined input/output device (illustrated in Fig. 10 with a dashed line surrounding the input device 1012 and the output device 1014). An example of such a combined device is a touch sensitive display, also sometimes referred to as a "touch screen display" or simply "touch screen". In such an embodiment, input to the device may be provided by a movement of a physical object, such as e.g. a stylus or a finger of a user, on or near the touch screen display.

A network adapter 1016 may also be coupled to the data processing system to enable it to become coupled to other systems, computer systems, remote network devices, and/or remote storage devices through intervening private or public networks. The network adapter may comprise a data receiver for receiving data that is transmitted by said systems, devices and/or networks to the data processing system 1000, and a data transmitter for transmitting data from the data processing system 1000 to said systems, devices and/or networks. Modems, cable modems, and Ethernet cards are examples of different types of network adapter that may be used with the data processing system 1000.

As pictured in Fig. 10, the memory elements 1004 may store an application 1018. In various embodiments, the application 1018 may be stored in the local memory 1008, the one or more bulk storage devices 1010, or apart from the local memory and the bulk storage devices. It should be appreciated that the data processing system 1000 may further execute an operating system (not shown in Fig. 10) that can facilitate execution of the application 1018. The application 1018, being implemented in the form of executable program code, can be executed by the data processing system 1000, e.g., by the processor 1002. Responsive to executing the application, the data processing system 1000 may be configured to perform one or more operations or method steps described herein.

In one aspect of the present invention, the data processing system 1000 may represent a computer for performing the simulation as described herein or a module for controlling one of the apparatuses for performing calibration experiments.

Various embodiments of the invention may be implemented as a program product for use with a computer system, where the program(s) of the program product define functions of the embodiments (including the methods described herein). In one embodiment, the program(s) can be contained on a variety of non-transitory computer-readable storage media, where, as used herein, the expression "non-transitory computer readable storage media" comprises all computer-readable media, with the sole exception being a transitory, propagating signal. In another embodiment, the program(s) can be contained on a variety of transitory computer-readable storage media. Illustrative computer-readable storage media include, but are not limited to: (i) non-writable storage media (e.g., read-only memory devices within a computer such as CD-ROM disks readable by a CD-ROM drive, ROM chips or any type of solid-state non-volatile semiconductor memory) on which information is permanently stored; and (ii) writable storage media (e.g., flash memory, floppy disks within a diskette drive or hard-disk drive or any type of solid-state random-access semiconductor memory) on which alterable information is stored. The computer program may be run on the processor 1002 described herein.

The terminology used herein is for the purpose of describing particular embodiments only and is not intended to be limiting of the invention. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

The corresponding structures, materials, acts, and equivalents of all means or step plus function elements in the claims below are intended to include any structure, material, or act for performing the function in combination with other claimed elements as specifically claimed. The description of embodiments of the present invention has been presented for purposes of illustration, but is not intended to be exhaustive or limited to the implementations in the form disclosed. Many modifications and variations will be apparent to those of ordinary skill in the art without departing from the scope and spirit of the present invention. The embodiments were chosen and described in order to best explain the principles and some practical applications of the present invention, and to enable others of ordinary skill in the art to understand the present invention for various embodiments with various modifications as are suited to the particular use contemplated.

**Claims**

1.  A computer-implemented method for simulating a mixing process of mixing fodder in a fodder mixing device, the fodder comprising at least a first fodder component and a second fodder component, the method comprising

    storing a first virtual representation of one or more surfaces that form a mixing chamber of the fodder mixing device; and

    storing a second virtual representation of one or more surfaces that form a mixing actuator of the fodder mixing device, the second virtual representation defining a position of the mixing actuator relative to the mixing chamber; and

    storing a third virtual representation of the first fodder component, the third representation defining particles of a first type and their respective positions relative to the mixing chamber and defining an interaction between at least a first and second particle of the first type, the interaction defining a dependence of an interaction force between the first and second particle on a distance between the first and second particle;

    storing a fourth virtual representation of the second fodder component, the fourth representation defining particles of a second type and their respective positions relative to the mixing chamber; the method comprising

    repeatedly performing a sequence of steps, the sequence comprising steps i-iv:

    (i) based on the stored representations, determining a resultant force on each defined particle,

    (ii) for each particle, based on its determined resultant force, solving an equation of motion for determining a further position of each particle at a further time instance;

    (iii) updating the stored third and fourth representation comprising updating the respective positions of the particles to be the respective further positions of the particles;

    (iv) updating the second representation, the updated second representation defining a further position of the mixing actuator relative to the mixing chamber at a further time instance, wherein

    at least one of the performed sequences comprises determining said interaction force based on a distance between the first and second particle and based on the defined interaction and comprises determining that the interaction force, or a derived interaction force determined based on the interaction force, exceeds a threshold value and comprises, based on this determination, irrevocably nullifying the defined interaction.

2.  The method according to claim 1, wherein
    at least one of the first and second virtual representation comprises a non-uniform rational basis spline (NURBS) representing at least one curved surface of said one or more surfaces.

3.  The method according to one or more of the preceding claims, further comprising
    storing a further interaction defining a dependence of a further interaction force between the first and second particle on a distance between the first and second particle, wherein determining the resultant force on the first particle comprises
    determining said further interaction force between the first and second particle based on the further interaction and on the distance between the first and second particle, and
    determining the resultant force based on the interaction force and on the further interaction force, e.g. by adding up the interaction force and the further interaction force.

4.  The method according to one or more of the preceding claims, further comprising
    storing a surface interaction defining a dependence of a surface interaction force between a surface and the first particle on a distance between the first particle and the surface, and
    determining the surface interaction force between the first particle and the surface based on the defined surface interaction and based on a distance between the first particle and the surface, and
    determining the resultant force on the first particle based on the interaction force, and the surface interaction force, e.g. by adding up the interaction force, the further interaction force and the surface interaction force.

5.  The method according to one or more of the preceding claims, wherein
    the third representation defines at least one particle parameter for the particles of the first type, wherein the particle parameter has been determined based on a calibration experiment involving the first fodder component and based on a simulation of the calibration experiment involving a representation of the first fodder component, wherein
    the calibration experiment comprises subjecting an amount of the first fodder component to a manipulation and measuring a bulk response of said amount of first fodder component to the manipulation; wherein
    determination of the at least one particle parameter comprises selecting the at least one particle parameter such that the simulated response of the representation of the first fodder component resembles the response measured during the calibration experiment.

6. The method according to the preceding claim, wherein the calibration experiment comprises
inserting an amount of the first fodder component into a rotatable drum,
rotating the drum and measuring the response of the amount of the first fodder component in response to the rotation of the drum.

7. The method according to one or more of the preceding claims 4-5, wherein the calibration experiment comprises applying a compressive force to an amount of the first fodder component, the first fodder component being arranged in a cylinder, and measuring a wall force that is exerted by the first fodder component onto one or more walls of the cylinder during compression, wherein measuring the wall force comprises measuring the compressive force and measuring a base force that is exerted, due to the compression, by the fodder component onto a base surface of the cylinder that is separate from the one or more walls of the cylinder and subtracting the base force from the compressive force in order to determine the wall force exerted by the first fodder component onto one or more walls of the cylinder.

8. The method according to one or more of the preceding claims 4-6, wherein the calibration experiment comprises shearing an amount of fodder with an object, such as a blade, the object having a predetermined velocity at the moment of impact, and measuring an energy that is required for cutting through the amount of fodder with said object.

9. The method according to one or more of the preceding claims, wherein
the first fodder component consists of elements, and wherein
a simulated ratio between a size of the particles of the first type defined by the third representation and a size of the mixing chamber as represented by the first representation is larger than an actual ratio of a size of elements constituting the first fodder component and a size of the actual mixing chamber.

10. A computer program or suite of computer programs comprising at least one software code portion or a computer program product storing at least one software code portion, the software code portion, when run on a computer system, being configured for executing the method according to one or more of the claims 1-9.

11. A method for manufacturing a fodder mixing device comprising
designing a fodder mixing device comprising a mixing chamber and a mixing actuator for mixing at least the first and second fodder component, the designing comprising steps v-vii:

(v) for a first provisional design of the fodder mixing device, performing the computer-implemented method according to one or more of the preceding claims 1-9,
(vi) for a second provisional design of the fodder mixing device different from the first design, performing the computer-implemented method according to one or more of the preceding claims 1-9,
(vii) based on a determination that the simulation of the second provisional design yields better simulation results, selecting the second provisional design as design for the fodder mixing device, the method further comprising

manufacturing the fodder mixing device in accordance with the selected design.

12. A fodder mixing device obtained by the manufacturing method of claim 11.

13. A rotatable drum configured to hold fodder and manipulate the fodder by rotating, the rotatable drum having a diameter of at least 0.5 meter.

14. An apparatus for performing the calibration experiment mentioned in claim 6, the apparatus comprising
a force application system for exerting a compressive force on an amount of fodder component, and a
compression measurement system for measuring a compression of the fodder component, and a
force measurement system for measuring the force exerted on the fodder component by the force application system.

15. An apparatus for performing the calibration experiment mentioned in claim 7, the apparatus comprising
a fodder holding device for holding an amount of fodder, and
an impacting device, such as blade, and
an impact generating system for causing the impacting device to shear the amount of fodder component in the fodder holding device with a predetermined velocity.

EP 3 671 523 A2

**Fig. 1**

**Fig. 2**

**Fig. 3**

**Fig. 4**

**Fig. 5**

A

B

C

**Fig. 6**

**Fig. 7**

EP 3 671 523 A2

Fig. 8

Fig. 9

EP 3 671 523 A2

**Fig. 10**

**EP 3 671 523 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CHEN, X.-D. ; YONG, J.-H. ; WANG, G. ; PAUL, G.-C. ; XU, G.** Computing the minimum distance between a point and a NURBS curve. Comput. *Aided Des.,* 2008, vol. 40, 1051-1054

- From soft and hard particle simulations to continuum theory for granular flows. **LUDING, S. ; RIVAS ABUD, N. ; WEINHART, T.** ALERT Doctoral School 2017: Discrete Element Modeling. 2017, 3-42